(19) Europäisches Patentamt
European Patent Office
Office européen des brevets

(11) **EP 4 311 394 B1**

(12) **FASCICULE DE BREVET EUROPEEN**

(45) Date de publication et mention
de la délivrance du brevet:
**04.12.2024 Bulletin 2024/49**

(21) Numéro de dépôt: **23183183.5**

(22) Date de dépôt: **04.07.2023**

(51) Classification Internationale des Brevets (IPC):
*H10N 70/20* *(2023.01)*

(52) Classification Coopérative des Brevets (CPC):
**H10N 70/231; H10N 70/063; H10N 70/823;
H10N 70/8613; H10N 70/8828; H10N 70/8833**

(54) **COMMUTATEUR À BASE DE MATÉRIAU À CHANGEMENT DE PHASE**

SCHALTER BASIEREND AUF PHASENWECHSELMATERIAL

SWITCH BASED ON PHASE CHANGE MATERIAL

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **18.07.2022 FR 2207296**

(43) Date de publication de la demande:
**24.01.2024 Bulletin 2024/04**

(73) Titulaire: **Commissariat à l'Energie Atomique et
aux Energies
Alternatives
75015 Paris (FR)**

(72) Inventeurs:
• **REIG, Bruno**
  **38054 Grenoble Cedex 09 (FR)**
• **MONFRAY, Stéphane**
  **38320 Eybens (FR)**
• **FLEURY, Alain**
  **73000 Barberaz (FR)**

(74) Mandataire: **Cabinet Beaumont
4, Place Robert Schuman
B.P. 1529
38025 Grenoble Cedex 1 (FR)**

(56) Documents cités:
**US-B1- 10 461 253    US-B1- 9 368 720**

**Description**

Domaine technique

La présente description concerne de façon générale les dispositifs électroniques. La présente description concerne plus particulièrement les commutateurs à base d'un matériau à changement de phase capable d'alterner entre une phase cristalline, électriquement conductrice, et une phase amorphe, électriquement isolante.

Technique antérieure

On connaît de nombreuses applications tirant profit de commutateurs, ou interrupteurs, à base d'un matériau à changement de phase pour permettre ou empêcher une circulation d'un courant électrique dans tout ou partie d'un circuit. De tels commutateurs peuvent notamment être mis en œuvre dans des applications de communication radiofréquence, par exemple pour commuter une antenne entre des modes d'émission et de réception, pour activer un filtre correspondant à une bande de fréquences, etc.

Résumé de l'invention

Il existe un besoin d'améliorer les commutateurs à base d'un matériau à changement de phase existants et leurs procédés de fabrication.

Un mode de réalisation pallie tout ou partie des inconvénients des commutateurs à base d'un matériau à changement de phase connus et de leurs procédés de fabrication.

Un aspect d'un mode de réalisation vise plus particulièrement à fournir un commutateur présentant une efficacité thermique améliorée.

Un aspect d'un autre mode de réalisation vise plus particulièrement à fournir un commutateur présentant des dimensions réduites.

Un aspect d'encore un autre mode de réalisation vise plus particulièrement à fournir un commutateur présentant une vitesse de commutation accrue.

Pour cela, un mode de réalisation prévoit un commutateur à base d'un matériau à changement de phase comprenant :

- une région en ledit matériau à changement de phase ;
- un élément chauffant électriquement isolé de la région en ledit matériau à changement de phase ; et
- un ou plusieurs piliers s'étendant dans la région en ledit matériau à changement de phase, le ou les piliers étant en un matériau présentant une conductivité thermique supérieure à celle dudit matériau à changement de phase.

Selon un mode de réalisation, le matériau du ou des piliers est électriquement isolant.

Selon un mode de réalisation, le matériau du ou des piliers est choisi parmi le nitrure d'aluminium et le nitrure de silicium.

Selon un mode de réalisation, ledit matériau à changement de phase est un matériau chalcogénure.

Selon un mode de réalisation, une couche électriquement isolante est interposée entre l'élément chauffant et la région en ledit matériau à changement de phase.

Selon un mode de réalisation, la couche électriquement isolante est en le même matériau que le ou les piliers.

Selon un mode de réalisation, la région en ledit matériau à changement de phase est plus proche d'un substrat, dans et sur lequel est formé le commutateur, que l'élément chauffant.

Selon un mode de réalisation, l'élément chauffant est plus proche d'un substrat, dans et sur lequel est formé le commutateur, que la région en ledit matériau à changement de phase.

Selon un mode de réalisation, la région en ledit matériau à changement de phase est revêtue d'une couche de passivation.

Selon un mode de réalisation, la région en ledit matériau à changement de phase relie des première et deuxième électrodes de conduction du commutateur.

Selon un mode de réalisation, chaque pilier présente une dimension latérale maximale égale à environ 300 nm.

Selon un mode de réalisation, chaque pilier est séparé des piliers voisins par une distance de l'ordre de 300 nm.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en perspective, schématique et partielle, d'un exemple d'un commutateur à base d'un matériau à changement de phase selon l'art antérieur ;

la figure 2 est une vue en coupe, selon le plan AA de la figure 1, du commutateur de la figure 1 ;

la figure 3 est une vue en perspective, schématique et partielle, d'un exemple d'un commutateur à base d'un matériau à changement de phase selon un mode de réalisation de la présente invention ;

la figure 4 est une vue en coupe, selon le plan AA de la figure 3, du commutateur de la figure 3 ;

la figure 5 est une vue en coupe, schématique et partielle, d'un exemple d'un commutateur à base d'un matériau à changement de phase selon un mode de réalisation de la présente invention ;

la figure 6A, la figure 6B et la figure 6C illustrent, par des vues en coupe schématiques et partielles, des étapes successives d'un exemple d'un procédé de fabrication du commutateur de la figure 3 selon un mode de réalisation ;

la figure 7 est une vue en perspective, schématique et partielle, d'un exemple d'un commutateur à base d'un matériau à changement de phase selon un mode de réalisation en dehors de la présente invention ;

la figure 8 est une vue en coupe, selon le plan AA de la figure 7, du commutateur de la figure 7 ;

la figure 9 est une vue en perspective, schématique et partielle, d'un exemple d'un commutateur à base d'un matériau à changement de phase selon un mode de réalisation en dehors de la présente invention ;

la figure 10 est une vue en coupe, schématique et partielle, d'un exemple d'un commutateur à base d'un matériau à changement de phase selon un mode de réalisation en dehors de la présente invention ;

la figure 11 est une vue en coupe, schématique et partielle, d'un exemple d'un commutateur à base d'un matériau à changement de phase selon un mode de réalisation en dehors de la présente invention ;

la figure 12A et la figure 12B illustrent, par des vues en coupe schématiques et partielles, des étapes successives d'un exemple d'un procédé de fabrication d'un commutateur à base d'un matériau à changement de phase selon un mode de réalisation en dehors de la présente invention

la figure 13A, la figure 13B, la figure 13C et la figure 13D illustrent, par des vues en coupe schématiques et partielles, des étapes successives d'un exemple d'un procédé de fabrication d'un commutateur à base d'un matériau à changement de phase selon un mode de réalisation en dehors de la présente invention ; et

la figure 14A et la figure 14B illustrent, par des vues en coupe schématiques et partielles, des étapes successives d'un exemple d'un procédé de fabrication d'un commutateur à base d'un matériau à changement de phase selon un mode de réalisation en dehors de la présente invention.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de commande des commutateurs à base d'un matériau à changement de phase et les applications dans lesquelles peuvent être prévus de tels commutateurs n'ont pas été détaillés, les modes de réalisation et variantes décrits étant compatibles avec les circuits de commande des commutateurs à base d'un matériau à changement de phase usuels et avec les applications usuelles mettant en œuvre des commutateurs à base d'un matériau à changement de phase.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence sauf précision contraire à l'orientation des figures.

Sauf précision contraire, les expressions « environ », « approximativement », « sensiblement », et « de l'ordre de » signifient à 10 % près, de préférence à 5 % près.

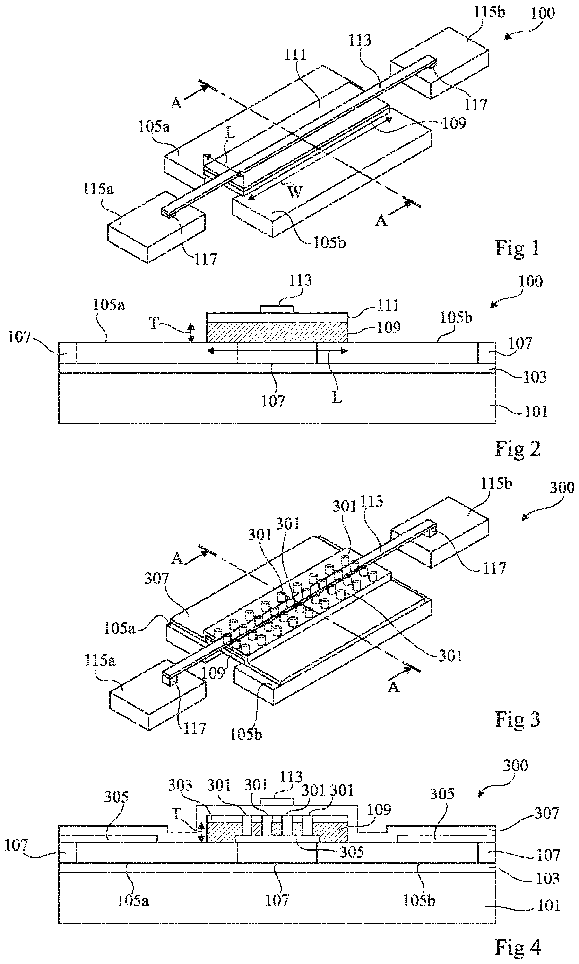

La figure 1 est une vue en perspective, schématique et partielle, d'un exemple d'un commutateur 100 à base d'un matériau à changement de phase selon l'art antérieur. La figure 2 est une vue en coupe, selon le plan AA de la figure 1, du commutateur 100 de la figure 1. Le plan AA de la figure 1 est sensiblement parallèle à une direction de conduction du commutateur 100.

Dans l'exemple représenté, le commutateur 100 est formé dans et sur un substrat 101, par exemple une plaquette ou un morceau de plaquette en un matériau semiconducteur. À titre d'exemple, le substrat 101 est en silicium et présente une résistivité de l'ordre de 100 $\Omega$.m (silicium dit « à haute résistivité »).

Dans cet exemple, le substrat 101 est revêtu sur l'une de ses faces (sa face supérieure, dans l'orientation de la figure 2) d'une couche électriquement isolante 103. À titre d'exemple, la couche 103 est en dioxyde de silicium ($SiO_2$) et présente une épaisseur de l'ordre de 500 nm.

Dans l'exemple représenté, le commutateur 100 comporte des première et deuxième électrodes de conduction 105a et 105b situées sur et en contact avec la face supérieure de la couche électriquement isolante 103. Les électrodes 105a et 105b sont par exemple destinées à être connectées à un circuit de communication radiofréquence, non détaillé sur les figures. Une distance par exemple de l'ordre de 1 $\mu$m sépare l'électrode 105a de l'électrode 105b. Les électrodes 105a et 105b sont en un matériau conducteur, par exemple un métal, par exemple le cuivre ou l'aluminium, ou en un alliage métallique. Chaque électrode 105a, 105b peut présenter une structure monocouche ou une structure multicouche comprenant par exemple, depuis la face supérieure de la couche 103, une couche en titane présentant une épaisseur de l'ordre de 10 nm, une couche en un alliage de cuivre et d'aluminium présentant une épaisseur de l'ordre de 440 nm, une autre couche en titane présentant une épaisseur de l'ordre de 10 nm et une couche en nitrure de titane (TiN) présentant une épaisseur de l'ordre de 100 nm.

Dans cet exemple, une autre couche électriquement isolante 107 revêt des parties de la face supérieure de la couche 103 non revêtues par les électrodes 105a et 105b. Dans l'exemple illustré, le matériau de la couche 107 entoure les électrodes 105a et 105b sur toutes leurs faces latérales. Une partie de la couche 107 s'étend en particulier entre les électrodes 105a et 105b, et isole électriquement l'électrode 105a de l'électrode 105b. La couche 107 affleure par exemple la face supérieure des électrodes 105a et 105b, comme illustré en figure 2. À titre d'exemple, la couche 107 est en le même matériau que la couche 103, par exemple le dioxyde de silicium.

Afin de ne pas surcharger le dessin, le substrat 101 et les couches électriquement isolantes 103 et 107 n'ont pas été représentés en figure 1.

Dans l'exemple représenté, le commutateur 100 comporte en outre une région 109 en un matériau à changement de phase reliant les première et deuxième électrodes de conduction 105a et 105b. Plus précisément, dans cet exemple, la région 109 revêt la face supérieure de la partie de la couche 107 séparant les électrodes de conduction 105a et 105b et se prolonge, par exemple sur une distance de l'ordre de 1 $\mu$m, sur et en contact avec une partie de la face supérieure de chaque électrode 105a, 105b. La région 109 présente par exemple une épaisseur T comprise entre 100 et 300 nm.

À titre d'exemple, la région 109 du commutateur 100 est en un matériau dit « chalcogénure », c'est-à-dire un matériau ou un alliage comprenant au moins un élément chalcogène, par exemple un matériau de la famille du tellurure de germanium (GeTe), du tellurure d'antimoine (SbTe) ou du germanium-antimoine-tellure (GeSbTe, communément désigné par l'acronyme « GST »). À titre de variante, la région 109 est en dioxyde de vanadium ($VO_2$).

De manière générale, les matériaux à changement de phase sont des matériaux capables d'alterner, sous l'effet d'une variation de température, entre une phase cristalline et une phase amorphe, la phase amorphe présentant une résistance électrique supérieure à celle de la phase cristalline. Dans le cas du commutateur 100, on tire profit de ce phénomène pour obtenir un état bloqué, empêchant la circulation d'un courant entre les électrodes de conduction 105a et 105b, lorsqu'une partie au moins du matériau de la région 109 située entre les électrodes de conduction est dans la phase amorphe, et un état passant, permettant la circulation du courant entre les électrodes 105a et 105b, lorsque le matériau de la région 109 est dans la phase cristalline.

Dans l'exemple représenté, la face supérieure de la région 109 est revêtue d'une couche électriquement isolante 111. À titre d'exemple, la couche 111 est en un matériau diélectrique et thermiquement conducteur, par exemple le nitrure de silicium (SiN) ou le nitrure d'aluminium (AlN).

Dans cet exemple, le commutateur 100 comporte en outre un élément chauffant 113 situé sur et en contact avec la face supérieure de la couche 111, à l'aplomb de la région 109 en matériau à changement de phase. L'élément chauffant 113 est électriquement isolé de la région 109 par la couche 111. Dans l'exemple représenté, l'élément chauffant 113 présente une forme de bande s'étendant le long d'une direction sensiblement orthogonale à la direction de conduction du commutateur 100. Dans cet exemple, les extrémités de l'élément chauffant 113 sont connectées respectivement à des troisième et quatrième électrodes de commande 115a et 115b du commutateur 100 au moyen de plots conducteurs 117. L'élément chauffant 113 présente par exemple une épaisseur de l'ordre de 100 nm. À titre d'exemple, l'élément chauffant 113 est en un métal, par exemple le tungstène, ou en un alliage métallique, par exemple le nitrure de titane.

Bien que cela n'ait pas été illustré sur les figures, la structure du commutateur 100 peut être revêtue, du côté de la face supérieure du substrat 101, d'une couche thermiquement isolante destinée à confiner la chaleur produite par l'élément chauffant 113.

Lors des commutations entre les états passant et bloqué, les électrodes de commande 115a et 115b du commutateur 100 sont par exemple destinées à être soumises à une tension de commande provoquant une circulation de courant à travers l'élément chauffant 113. Ce courant entraîne, par effet Joule puis par rayonnement et/ou conduction à l'intérieur de la structure du commutateur 100, notamment à travers la couche 111, une élévation de température de la région 109 depuis sa face supérieure, située en regard de l'élément chauffant 113.

Plus précisément, pour faire basculer le commutateur 100 de l'état bloqué à l'état passant, on chauffe la région 109 au moyen de l'élément chauffant 113, par exemple à une température T1 et pendant une durée d1. La température T1 et la durée d1 sont choisies de sorte à provoquer un changement de phase du matériau de la région 109 depuis la phase amorphe vers la phase cristalline. La température T1 est par exemple supérieure à une température de cristallisation et inférieure à une température de fusion du matériau de la région 109. À titre d'exemple, la température T1 est comprise entre 150 et 350 °C et la durée d1 est inférieure à 1 ps. Dans le cas où la région 109 est en tellurure de germanium, la température T1 est par exemple égale à environ 300 °C et la durée d1 est par exemple comprise entre 100 ns et 1 μs.

À l'inverse, pour faire basculer le commutateur 100 de l'état passant à l'état bloqué, on chauffe la région 109 au moyen de l'élément chauffant 113, par exemple à une température T2 supérieure à la température T1, et pendant une durée d2 inférieure à la durée d1. La température T2 et la durée d2 sont choisies de sorte à provoquer un changement de phase du matériau de la région 109 depuis la phase cristalline vers la phase amorphe. La température T2 est par exemple supérieure à la température de fusion du matériau à changement de phase. À titre d'exemple, la température T2 est comprise entre 600 et 1 000 °C et la durée d2 est inférieure à 500 ns. Dans le cas où la région 109 est en tellurure de germanium, la température T2 est par exemple égale à environ 700 °C et la durée d2 est par exemple égale à environ 100 ns.

Le commutateur 100 est dit « à chauffage indirect », l'élévation de température du matériau à changement de phase s'obtenant par circulation d'un courant à travers un élément chauffant électriquement isolé du matériau à changement de phase, par opposition aux commutateurs de type « à chauffage direct » qui sont dépourvus d'élément chauffant et dans lesquels l'élévation de température résulte d'une circulation de courant directement à travers le matériau à changement de phase. Dans le cas d'un commutateur à chauffage direct, les électrodes de commande sont par exemple connectées à deux côtés opposés de la région en matériau à changement de phase, par exemple le long d'une direction orthogonale au chemin de conduction du commutateur. Un inconvénient des commutateurs à chauffage direct tient au fait que, lorsque le commutateur est passant, un chemin de conduction électrique est créé à travers le matériau à changement de phase entre les électrodes de commande et les électrodes de conduction du commutateur. Cela entraîne des courants de fuite qui perturbent le signal transmis entre les électrodes de conduction.

Pour répondre aux contraintes de diverses applications, par exemple dans le domaine des communications radiofréquence, il est souhaitable que le commutateur 100 présente un facteur de mérite (« figure of merit », en anglais) le plus faible possible. Dans la présente description, le facteur de mérite d'un commutateur correspond à un produit d'une résistance $R_{ON}$ à l'état passant par une capacité $C_{OFF}$ à l'état bloqué de ce commutateur.

La résistance à l'état passant $R_{ON}$ des commutateurs de la présente description est définie par la relation suivante :

[Math 1]

$$R_{ON} = \frac{1}{\sigma_{ON}} \cdot \frac{L}{T \cdot W}$$

Dans la relation Math 1 ci-dessus, L, W et T désignent respectivement la longueur, la largeur et l'épaisseur de la région 109 en matériau à changement de phase, la longueur L et la largeur W correspondant à des dimensions de la région 109 mesurées le long de directions respectivement parallèles et orthogonales à la direction de conduction du commutateur, et $\sigma_{ON}$ désigne une conductivité du matériau à changement de phase (exprimée en siemens par mètre) lorsque celui-ci se trouve dans sa phase cristalline.

Afin de réduire le facteur de mérite du commutateur 100, on pourrait par exemple diminuer sa résistance à l'état passant $R_{ON}$ en augmentant l'épaisseur T de la région 109 en matériau à changement de phase. Cela entraînerait toutefois une augmentation indésirable des durées de commutation, ou une baisse de la vitesse de commutation, entre les états passant et bloqué. En effet, pour une même tension de commande, plus la région 109 est épaisse et plus les durées d1 et d2, correspondant respectivement aux durées de transition entre la phase amorphe et la phase cristalline et entre la phase cristalline et la phase amorphe, sont longues. Pour réduire les durées d1 et d2, on pourrait alors être tenté d'augmenter la tension de commande de l'élément chauffant 113 mais cela provoquerait une augmentation indésirable de la consommation énergétique du commutateur 100.

Des commutateurs à chauffage indirect semblables sont connus de US 10 461 253 B1 ou US 9 368 720 B1, par exemple. Dans ces dispositifs, un élément en un matériau à haute conductivité thermique, tel que l'AlN, le diamant ou le SiC (un via thermique), est disposé entre l'élément chauffant et la zone active du matériau à changement de phase, ce qui améliore leur vitesse de commutation.

La figure 3 est une vue en perspective, schématique et partielle, d'un exemple d'un commutateur 300 à base d'un matériau à changement de phase selon un mode de réalisation de la présente invention. La figure 4 est une vue en coupe, selon le plan AA de la figure 3, du commutateur 300 de la figure 3. Le commutateur 300 des figures 3 et 4 comprend des éléments communs avec le commutateur 100 des figures 1 et 2. Ces éléments communs ne seront pas détaillés à nouveau ci-après.

Selon un mode de réalisation, le commutateur 300 comprend un ou plusieurs piliers 301 (plusieurs dizaines de piliers 301, dans l'exemple représenté) s'étendant dans la région 109 en matériau à changement de phase. Plus précisément, dans l'exemple illustré en figures 3 et 4, les piliers 301 s'étendent verticalement à travers toute l'épaisseur T de la région 109.

Selon un mode de réalisation, le ou les piliers 301 sont en un matériau présentant une conductivité thermique supérieure à celle du matériau à changement de phase de la région 109. À titre d'exemple, les piliers 301 sont en un matériau électriquement isolant et thermiquement conducteur, par exemple le nitrure de silicium, le nitrure d'aluminium, etc. En variante, les piliers 301 peuvent être en un matériau électriquement et thermiquement conducteur, par exemple un métal. Toutefois, pour une mise en oeuvre du commutateur 300 dans des applications de communication radiofréquence, l'utilisation de piliers 301 en un matériau électriquement isolant est privilégiée afin de limiter ou d'éviter l'apparition de phénomènes capacitifs parasites.

Dans l'exemple représenté, les piliers 301 présentent chacun, en vue de dessus, une section sensiblement circulaire. Cet exemple n'est toutefois pas limitatif, le ou les piliers 301 pouvant présenter une forme quelconque, par exemple une section de forme rectangulaire ou carrée. À titre d'exemple, chaque pilier 301 présente une dimension latérale maximale (par exemple un diamètre, dans l'exemple représenté où les piliers ont une section sensiblement circulaire) égale à environ 300 nm. En outre, chaque pilier 301 est par exemple séparé des piliers 301 voisins par une distance de l'ordre de 300 nm. Les piliers 301 sont par exemple répartis selon un motif périodique. Bien que l'on ait illustré un exemple dans lequel le commutateur 300 comporte quelques dizaines de piliers 301, le commutateur 300 peut comporter un nombre quelconque de piliers 301.

Un avantage résultant de la présence des piliers 301 tient au fait que la chaleur produite par l'élément chauffant 113 est propagée plus efficacement dans la région 109 du commutateur 300. En particulier, par rapport au commutateur 100 dont la région 109 est chauffée principalement depuis sa face supérieure, la chaleur provenant de l'élément chauffant 113 du commutateur 300 se diffuse en outre au coeur du matériau à changement de phase de la région 109. Le commutateur 300 présente ainsi une efficacité thermique supérieure à celle du commutateur 100.

Dans le cas du commutateur 300, pour une même tension de commande appliquée entre les électrodes 115a et 115b, l'élément chauffant 113 subit, par rapport au commutateur 100, une élévation de température moindre. En outre, pour une même tension de commande, la région 109 du commutateur 300 subit, par rapport à la région 109 du commutateur 100, une élévation de température plus importante. La différence entre les températures atteintes respectivement par l'élément chauffant 113 et par la région 109 lors des étapes de commutation est moindre dans le cas du commutateur 300 que dans le cas du commutateur 100.

À épaisseurs T de région 109 comparables, le commutateur 300 permet d'accéder à des durées de commutation inférieures, ou à des vitesses de commutation supérieures, à celles du commutateur 100. Il est avantageusement possible de tirer profit de l'efficacité thermique accrue du commutateur 300 pour augmenter l'épaisseur T de la région 109 par rapport au commutateur 100, afin de diminuer le facteur de mérite du commutateur 300, sans dégrader les durées de commutation par rapport au commutateur 100. On peut en outre avantageusement éloigner l'élément chauffant 113 par rapport à la région 109. Cela provoque alors une diminution de la capacité à l'état bloqué $C_{OFF}$, donc une baisse du facteur de mérite, du commutateur 300 par rapport au commutateur 100.

La face supérieure de la région 109 du commutateur 300 peut être, comme dans l'exemple illustré, intégralement revêtue d'une couche électriquement isolante 303. La couche 303 optionnelle permet par exemple de passiver la face supérieure de la région 109. La couche 303 permet en outre de réduire la capacité à l'état bloqué $C_{OFF}$ du commutateur 300 par rapport au commutateur 100, donc de diminuer le facteur de mérite du commutateur 300. Dans l'exemple représenté, les piliers 301 traversent la couche 303 sur toute son épaisseur. Plus précisément, dans cet exemple, chaque pilier 301 s'étend verticalement depuis la face supérieure de la couche 303 jusqu'à la face inférieure de la région 109. La couche 303 présente par exemple une épaisseur comprise entre 200 et 300 nm. À titre d'exemple, la couche 303 est en nitrure de silicium ou en nitrure de germanium (GeN).

Dans l'exemple illustré, le commutateur 300 comprend en outre, de façon optionnelle, des régions électriquement isolantes 305 disjointes revêtant la face supérieure de la couche électriquement isolante 107 et se prolongeant sur une partie de la face supérieure de chaque électrode de conduction 105a, 105b. Chaque région 305 présente par exemple une épaisseur de l'ordre de 20 nm. À titre d'exemple, les régions électriquement isolantes 305 sont en un matériau diélectrique, par exemple le nitrure de silicium.

Afin de ne pas surcharger le dessin, le substrat 101, les couches électriquement isolantes 103 et 107 et les régions électriquement isolantes 305 n'ont pas été représentés en figure 3.

Dans l'exemple représenté, le commutateur 300 comporte en outre une couche électriquement isolante 307. La couche 307 du commutateur 300 est par exemple analogue à la couche 111 du commutateur 100. Dans le commutateur 300, la couche 307 est interposée entre la couche 303 et l'élément chauffant 113. Plus précisément, dans l'exemple illustré, la couche 307 revêt la face supérieure des piliers 301, la face supérieure et les flancs de la couche 303, les flancs de la région 109, les parties exposées des électrodes 105a et 105b et la face supérieure et les flancs des régions 305. À titre d'exemple, la couche 307 est en un matériau électriquement isolant et thermiquement conducteur, par exemple le même matériau que celui des piliers 301, par exemple le nitrure de silicium ou le nitrure d'aluminium.

Bien que cela n'ait pas été illustré sur les figures, la structure du commutateur 300 peut être revêtue, du côté de la face supérieure du substrat 101, d'une couche thermiquement isolante destinée à confiner la chaleur produite par l'élément chauffant 113.

Le commutateur 300 présente une structure dans laquelle l'élément chauffant 113 est plus éloigné du substrat 101 que la couche 109 en matériau à changement de phase. Cela implique une capacité thermique faible, l'élément chauffant 113 pouvant être situé à proximité de l'air ambiant. Il en résulte avantageusement des échanges thermiques rapides, donc des durées de commutation faibles.

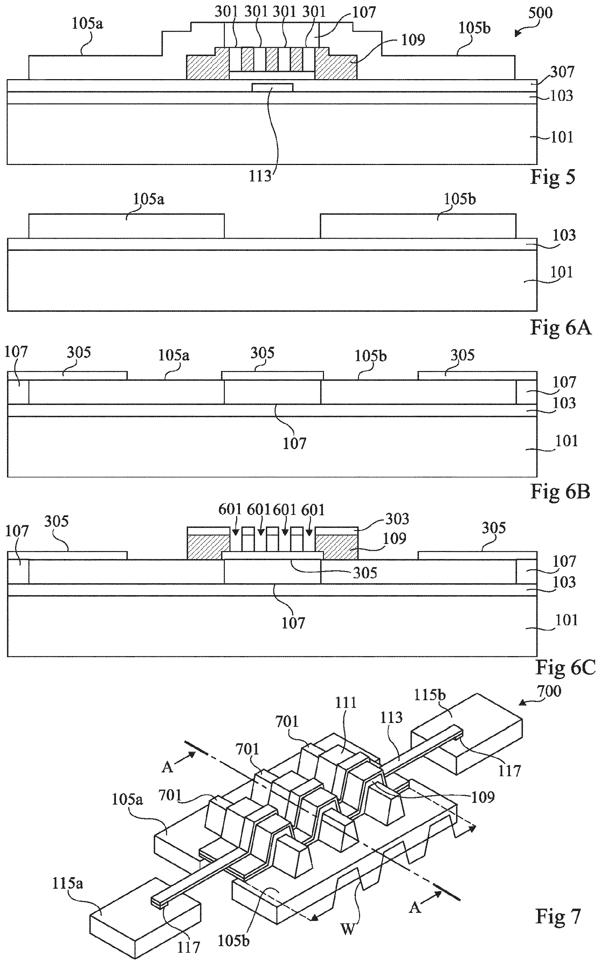

La figure 5 est une vue en coupe, schématique et partielle, d'un exemple d'un commutateur 500 à base d'un matériau à changement de phase selon un mode de réalisation de la présente invention.

Le commutateur 500 de la figure 5 comprend des éléments communs avec le commutateur 300 des figures 3 et 4. Ces éléments communs ne seront pas détaillés à nouveau ci-après. À la différence du commutateur 300 des figures 3 et 4, dans lequel la région 109 en matériau à changement de phase est située au-dessous de l'élément chauffant 113, la région 109 du commutateur 500 est, dans l'orientation de la figure 5, située au-dessus de l'élément chauffant 113.

Dans l'exemple représenté, l'élément chauffant 113 est plus précisément sur et en contact avec la face supérieure de la couche électriquement isolante 103. En outre, dans cet exemple, la couche électriquement isolante 307 revêt la face supérieure et les flancs de l'élément chauffant 113 et se prolonge sur des parties de la face supérieure de la couche 103 non revêtues par l'élément chauffant 113.

Dans l'exemple illustré en figure 5, la région 109 en matériau à changement de phase, traversée par les piliers 301, est située sur et en contact avec la face supérieure de la couche 307, à l'aplomb de l'élément chauffant 113. Dans cet exemple, les électrodes de conduction 105a et 105b du commutateur 500 sont sur et en contact avec la face supérieure de la couche 307. En outre, les électrodes 105a et 105b revêtent chacune un flanc et une partie de la face supérieure de la région 109.

Dans l'exemple représenté, la couche électriquement isolante 107 s'étend entre les électrodes 105a et 105b. La couche 107 est, dans l'orientation de la figure 5, sur et en contact avec la face supérieure de la région 109.

Bien que cela n'ait pas été illustré en figure 5, le commutateur 500 peut en outre comporter une couche de passivation de la région 109 et des régions électriquement isolantes analogues respectivement à la couche 303 et aux régions 305 du commutateur 300 des figures 3 et 4.

Par rapport au commutateur 300, le commutateur 500 présente une structure dans laquelle l'élément chauffant 113 est plus proche du substrat 101. Cela implique, dans le cas du commutateur 500, une capacité thermique supérieure qui favorise l'application d'une tension de commande moindre sur l'élément chauffant 113, par rapport au commutateur 300, pour obtenir une élévation comparable de la température de la région 109 lors des commutations.

Les figures 6A à 6C illustrent, par des vues en coupe schématiques et partielles, des étapes successives d'un exemple d'un procédé de fabrication du commutateur 300 de la figure 3 selon un mode de réalisation.

La figure 6A illustre plus précisément une étape de formation de la couche électriquement isolante 103 sur la face supérieure du substrat 101, par exemple par oxydation thermique du matériau du substrat 101. La figure 6A illustre en outre une étape de réalisation des électrodes de conduction 105a et 105b sur la face supérieure de la couche 103. À titre d'exemple, un niveau de métallisation est d'abord déposé, par exemple par dépôt physique en phase vapeur (« Physical Vapor Déposition » - PVD, en anglais) d'une ou plusieurs couches métalliques, du côté de la face supérieure du substrat 101. Des étapes de photolithographie puis gravure permettent ensuite de conserver uniquement des parties du niveau de métallisation qui sont situées aux emplacements souhaités des électrodes 105a et 105b. Des lignes radiofréquence, non représentées en figure 6A, peuvent en outre être formées dans le premier niveau de métallisation au cours de cette étape.

La figure 6B illustre une étape de formation de la couche électriquement isolante 107 autour des électrodes 105a et 105b. À titre d'exemple, la couche 107 est d'abord déposée, par exemple par dépôt chimique en phase vapeur assisté par plasma (« Plasma-Enhanced Chemical Vapor Déposition » - PECVD, en anglais), par exemple plus précisément par dépôt chimique en phase vapeur assisté par plasma à haute densité (« High-Density Plasma-Enhanced Chemical Vapor Déposition » - HDPCVD ou HDP PECVD, en anglais), du côté de la face supérieure de la structure de la figure 6A. La couche 107 peut, après dépôt, revêtir les électrodes 105a et 105b et présenter une épaisseur par exemple de l'ordre de 700 nm. Une étape de planarisation, par exemple par polissage mécano-chimique, permet ensuite d'exposer les faces supérieures des électrodes 105a et 105b. La couche 107 présente par exemple alors une épaisseur sensiblement égale à celle des électrodes 105a et 105b.

La figure 6B illustre en outre une étape de formation des régions électriquement isolantes 305. À titre d'exemple, une couche électriquement isolante est d'abord déposée du côté de la face supérieure du substrat 101. Des étapes de photolithographie puis gravure permettent alors de conserver des parties de la couche électriquement isolante situées aux emplacements souhaités des régions 305. À titre de variante, les régions 305 peuvent être formées par dépôt localisé d'un matériau électriquement isolant du côté de la face supérieure du substrat 101.

La figure 6C illustre une étape de formation de la région 109 en matériau à changement de phase et de la couche de passivation 303. À titre d'exemple, une couche en matériau à changement de phase et une couche de passivation sont successivement déposées, par exemple par dépôt physique en phase vapeur, du côté de la face supérieure de la structure de la figure 6B. Des étapes de photolithographie puis gravure, par exemple par gravure ionique réactive (« Reactive Ion Etching » - RIE, en anglais) ou par gravure par faisceau ionique (« Ion Beam Etching » - IBE, en anglais), permettent ensuite de conserver uniquement des parties de la couche en matériau à changement de phase et de la couche de passivation aux emplacements souhaités de la région 109 et de la couche 303. Au cours de ces étapes, des ouvertures 601 peuvent en outre être formées dans la couche en matériau à changement de phase et dans la couche de passivation aux emplacements souhaités des piliers 301. À titre de variante, les ouvertures 601 peuvent être formées après des étapes de photolithographie puis gravure postérieures aux étapes de formation de la région 109 et de la couche 303.

Au cours d'une autre étape, postérieure aux étapes décrites en relation avec la figure 6C, les ouvertures 601 sont intégralement comblées pour former les piliers 301. La couche électriquement isolante 307 est ensuite déposée sur toute la face supérieure de la structure. Dans le cas où les piliers 301 et la couche 307 sont en le même matériau, les piliers 301 sont par exemple formés lors du dépôt de la couche 307. L'élément chauffant 113 est ensuite formé sur et en contact avec la face supérieure de la couche 307. Les électrodes de commande 115a et 115b et les plots 117 peuvent en outre être réalisés au cours de l'étape de formation de l'élément chauffant 113, par exemple à partir d'un même niveau de métallisation. À l'issue de ces étapes, on obtient le commutateur 300 de la figure 3.

La personne du métier est capable d'adapter le procédé de fabrication du commutateur 300 décrit ci-dessus en relation avec les figures 6A à 6C pour réaliser le commutateur 500.

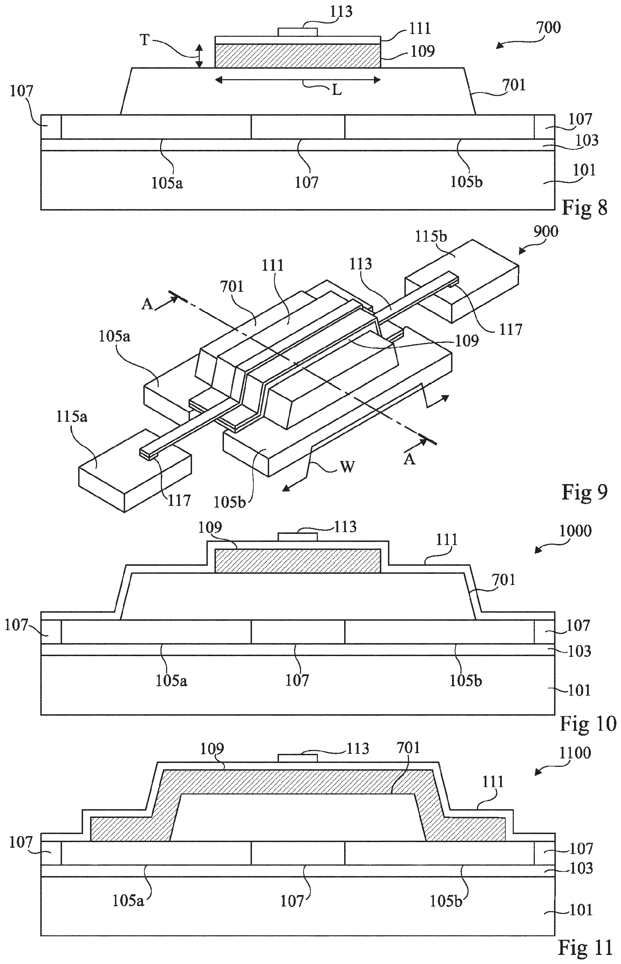

La figure 7 est une vue en perspective, schématique et partielle, d'un exemple d'un commutateur 700 à base d'un matériau à changement de phase selon un mode de réalisation en dehors de la présente invention. La figure 8 est une vue en coupe, selon le plan AA de la figure 7, du commutateur de la figure 7. Le plan AA de la figure 7 est sensiblement parallèle à une direction de conduction du commutateur 700.

Le commutateur 700 des figures 7 et 8 comprend des éléments communs avec le commutateur 100 des figures 1 et 2. Ces éléments communs ne seront pas détaillés à nouveau ci-après.

Afin de ne pas surcharger le dessin, le substrat 101 et les couches électriquement isolantes 103 et 107 n'ont pas été représentés en figure 7.

Selon un mode de réalisation, le commutateur 700 des figures 7 et 8 comprend un ou plusieurs îlots 701 (trois îlots 701, dans l'exemple représenté) électriquement isolants présentant chacun une première face (la face inférieure, dans l'orientation des figures 7 et 8) s'étendant sur et en contact avec les première et deuxième électrodes de conduction 105a et 105b du commutateur 700. Dans le commutateur 700, la région 109 en matériau à changement de phase s'étend sur une partie des flancs et sur une partie d'une deuxième face (la face supérieure, dans l'orientation des figures 7 et 8), opposée à la première face, de chaque îlot 701. Plus précisément, dans l'exemple représenté, la région 109 revêt une partie des flancs des îlots 701 qui sont sensiblement parallèles au plan AA de la figure 7, c'est-à-dire les flancs des îlots 701 s'étendant le long de la direction de conduction du commutateur 700. Dans l'exemple représenté, l'élément chauffant 113 du commutateur 700 s'étend en outre, le long d'une direction orthogonale à la direction de conduction du commutateur 700, sur et en contact avec une partie de la face supérieure de la région 109.

Les îlots 701 sont en un matériau diélectrique ou comprennent un empilement de matériaux diélectriques. À titre d'exemple, les îlots 701 sont en un matériau électriquement isolant et thermiquement conducteur, par exemple un matériau présentant une conductivité thermique supérieure à celle du matériau à changement de phase de la région 109, par exemple le nitrure d'aluminium. Cela permet avantageusement d'obtenir une résistance thermique moindre entre l'élément chauffant 113 et la région 109. On favorise ainsi un phénomène de « trempe » se produisant lors du passage de la région 109 de la phase cristalline à la phase amorphe. À titre de variante, les îlots 701 peuvent être en dioxyde de silicium.

Dans l'exemple illustré en figure 7, chaque îlot 701 présente une forme allongée le long de la direction de conduction du commutateur 700 et une section de forme sensiblement trapézoïdale, la première face de chaque îlot 701 présentant une surface plus importante que la deuxième face. Le fait de prévoir des îlots 701 présentant une section trapézoïdale, les flancs des îlots 701 étant ainsi inclinés, permet avantageusement de faciliter le revêtement des îlots 701 par la région 109 par rapport à un cas où les îlots 701 présenteraient des flancs verticaux, perpendiculaires aux première et deuxième faces. L'exemple illustré en figure 7 n'est toutefois pas limitatif, chaque îlot 701 pouvant en variante présenter une section de forme quelconque, par exemple rectangulaire ou carrée. Les îlots 701 sont par exemple répartis à intervalles réguliers le long de l'élément chauffant (113).

Dans le commutateur 700 de la figure 7, la région 109 en matériau à changement de phase est développée sur une structure tridimensionnelle, ou en relief, à la différence du commutateur 100 dans lequel la région 109 est sensiblement plane. Cela permet avantageusement d'augmenter la largeur W de la région 109 en matériau à changement de phase et/ou de réduire les dimensions extérieures du commutateur.

Plus précisément, le commutateur 700 peut présenter, par rapport au commutateur 100, une distance entre ses électrodes de commande 115a et 115b moindre tout en conservant une région 109 présentant une largeur W sensiblement égale à celle de la région 109 du commutateur 100. Cela permet avantageusement au commutateur 700 de présenter des dimensions extérieures inférieures, donc une densité d'intégration supérieure, par rapport au commutateur 100.

À titre d'exemple, dans un cas où le commutateur 700 comporte deux îlots 701 présentant une hauteur de l'ordre de 5 $\mu$m, une largeur, correspondant à une dimension latérale moyenne de l'îlot 701 mesurée le long d'une direction perpendiculaire au plan AA de la figure 7 (direction parallèle à l'axe de l'élément chauffant 113), de l'ordre de 1 $\mu$m et un espacement de l'ordre de 1 $\mu$m, la largeur W de la région 109, développée sur la structure tridimensionnelle, est de l'ordre de 25 $\mu$m. Le commutateur 700 présente dans ce cas une largeur, correspondant sensiblement à une dimension des électrodes de conduction 105a et 105b prise orthogonalement au plan AA de la figure 7, de l'ordre de 5 $\mu$m. En comparaison, la largeur du commutateur 100 est de l'ordre de 25 $\mu$m dans un cas où sa région 109 présente une largeur W égale à environ 25 $\mu$m.

À titre de variante, on peut prévoir que la région 109 du commutateur 700 présente une largeur W supérieure à celle de la région 109 du commutateur 100, tout en conservant une distance entre les électrodes 115a et 115b inférieure ou égale à la distance entre les électrodes 115a et 115b du commutateur 100. Cela permet avantageusement au commutateur 700 de présenter une résistance à l'état passant $R_{ON}$ inférieure, donc un facteur de mérite inférieur, par rapport au commutateur 100.

À titre de variante, on peut prévoir que la région 109 du commutateur 700 présente une largeur W supérieure et une épaisseur T inférieure à celle de la région 109 du commutateur 100, tout en conservant une résistance à l'état passant $R_{ON}$ comparable. Le fait de réduire l'épaisseur T de la région 109 permet avantageusement d'obtenir des changements de phases plus rapides lors des commutations. En outre, la réduction de l'épaisseur T de la région 109 permet d'obtenir un matériau à changement de phase de meilleure qualité cristallographique et stœchiométrique. De ce fait, les changements de phase du matériau de la région 109 nécessiteront avantageusement une énergie moindre. On améliore ainsi l'efficacité thermique du commutateur 700 par rapport au commutateur 100.

Un autre avantage du commutateur 700 tient au fait que la présence des îlots 701 permet de diminuer la capacité à l'état bloqué $C_{OFF}$. Les îlots 701 permettent plus précisément de réduire une capacité parasite Cp entre l'élément chauffant 113 et les électrodes de conduction 105a et 105b du commutateur 700, du fait que chaque îlot 701 éloigne l'élément chauffant 113 par rapport aux électrodes 105a et 105b. La capacité à l'état bloqué $C_{OFF}$ est en outre réduite, par rapport au commutateur 100, dans un cas où la largeur du commutateur 700 est inférieure à celle du commutateur 100.

Un autre avantage du commutateur 700 tient au fait que la présence des îlots 701 permet, à largeur W identique, de diminuer l'inductance de l'élément chauffant 113 par rapport au cas du commutateur 100. Cela semble provenir du fait que l'inductance mutuelle entre les tronçons verticaux adjacents de l'élément chauffant 113 devient négative, entraînant ainsi une réduction de l'inductance totale. Une baisse d'inductance de l'élément chauffant 113 permet avantageusement d'atteindre des vitesses de commutation plus élevées.

Bien que cela n'ait pas été illustré en figures 7 et 8, le commutateur 700 peut comporter une couche de passivation et des régions isolantes identiques ou analogues à la couche de passivation 303 et aux régions 305 du commutateur 300 des figures 3 et 4.

La figure 9 est une vue en perspective, schématique et partielle, d'un exemple d'un commutateur 900 à base d'un matériau à changement de phase selon un mode de réalisation en dehors de la présente invention.

Le commutateur 900 de la figure 9 comprend des éléments communs avec le commutateur 700 des figures 7 et 8. Ces éléments communs ne seront pas détaillés à nouveau ci-après.

Afin de ne pas surcharger le dessin, le substrat 101 et les couches électriquement isolantes 103 et 107 n'ont pas été représentés en figure 9.

Le commutateur 900 de la figure 9 diffère du commutateur 700 des figures 7 et 8 en ce que le commutateur 900 comprend un seul îlot 701 interposé entre la région 109 en matériau à changement de phase et les électrodes de conduction 105a et 105b.

Le commutateur 900 présente, vu en coupe selon le plan AA de la figure 9, une structure analogue à celle précédemment exposée en relation avec la figure 8.

Dans le commutateur 900, l'îlot 701 présente des dimensions, en particulier une largeur, telles que la majorité de la région 109 revêt l'îlot 701. Cela permet avantageusement d'éloigner encore davantage l'élément chauffant 113 par rapport aux électrodes de conduction 105a et 105b, donc de réduire la capacité à l'état bloqué $C_{OFF}$ du commutateur 900 par rapport au commutateur 700.

La figure 10 est une vue en coupe, schématique et partielle, d'un exemple d'un commutateur 1000 à base d'un matériau à changement de phase selon un mode de réalisation en dehors de la présente invention.

Le commutateur 1000 de la figure 10 comprend des éléments communs avec le commutateur 700 des figures 7 et 8. Ces éléments communs ne seront pas détaillés à nouveau ci-après.

Le commutateur 1000 de la figure 10 diffère du commutateur 700 des figures 7 et 8 en ce que, dans le commutateur 1000, la couche électriquement isolante 111 s'étend sur toute la face supérieure de la structure. Dans l'exemple représenté, la couche électriquement isolante 111 revêt la région 109 en matériau à changement de phase et les îlots 701 en matériau diélectrique. Plus précisément, dans cet exemple, la couche 111 revêt la face supérieure et les flancs de la région 109 en matériau à changement de phase, des parties de la face supérieure de chaque îlot 701 non revêtues par la région 109, tous les flancs de chaque îlot 701, des parties de la face supérieure de chaque électrode de conduction 105a, 105b non revêtues par les îlots 701, et des parties de la face supérieure de la couche électriquement isolante 107 non revêtues par les îlots 701.

Le fait de prévoir que la couche 111 recouvre toute la structure permet de simplifier la fabrication du commutateur 1000, notamment par rapport aux commutateurs 700 et 900.

La figure 11 est une vue en coupe, schématique et partielle, d'un exemple d'un commutateur 1100 à base d'un matériau à changement de phase selon un mode de réalisation en dehors de la présente invention.

Le commutateur 1100 de la figure 11 comprend des éléments communs avec le commutateur 700 des figures 7 et 8. Ces éléments communs ne seront pas détaillés à nouveau ci-après.

Le commutateur 1100 de la figure 11 diffère du commutateur 700 des figures 7 et 8 en ce que, dans le commutateur 1100, la région 109 en matériau à changement de phase revêt chaque îlot 701 en matériau diélectrique et la couche électriquement isolante 111 s'étend sur toute la face supérieure de la structure. Plus précisément, dans l'exemple représenté, la région 109 en matériau à changement de phase revêt la face supérieure et tous les flancs de chaque îlot 701 et se prolonge sur et en contact avec une partie de la face supérieure de chaque électrode de conduction 105a, 105b du commutateur 1100. En outre, dans cet exemple, la couche 111 revêt la face supérieure et les flancs de la région 109 en matériau à changement de phase, des parties de la face supérieure de chaque électrode de conduction 105a, 105b non revêtues par la région 109, et des parties de la face supérieure de la couche 107 électriquement isolante non revêtues par les îlots 701.

Dans le commutateur 1100, la partie de la région 109 s'étendant sur et en contact avec les électrodes de conduction 105a et 105b procure avantageusement un meilleur contact électrique entre la région 109 en matériau à changement de phase et les électrodes 105a et 105b que dans les commutateurs 700, 900 et 1000. Cela permet en outre de simplifier la fabrication du commutateur 1100, notamment par rapport aux commutateurs 700, 900 et 1000. La personne du métier est capable d'adapter les modes de réalisation des commutateurs 1000 et 1100 décrits en relation avec les figures 10 et 11 à des commutateurs comportant un nombre quelconque d'îlots 701.

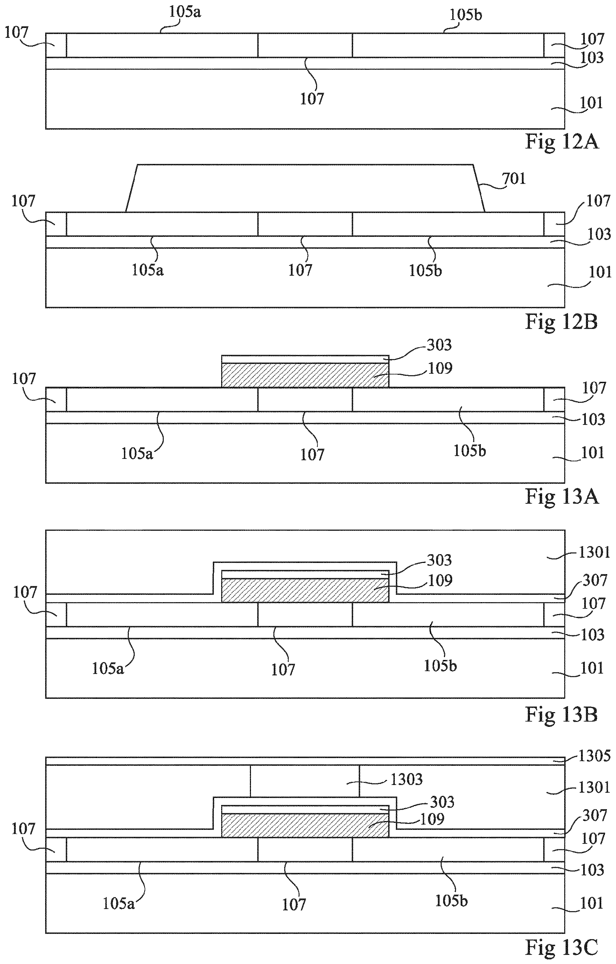

Les figures 12A et 12B illustrent, par des vues en coupe schématiques et partielles, des étapes successives d'un exemple d'un procédé de fabrication d'un commutateur à base d'un matériau à changement de phase selon un mode de réalisation en dehors de la présente invention, par exemple le commutateur 700 de la figure 7.

La figure 12A illustre plus précisément une structure obtenue à l'issue d'étapes successives de formation de la couche électriquement isolante 103, de réalisation des électrodes de commande 105a et 105b et de dépôt puis planarisation de la couche 107. Ces étapes sont par exemple mises en oeuvre de façon identique ou analogue à ce qui a été précédemment exposé en relation avec la figure 6A.

La figure 12B illustre une étape de formation des îlots 701 du côté de la face supérieure de la structure. À titre d'exemple, une couche de nitrure d'aluminium ou un empilement comprenant une couche de nitrure d'aluminium et une couche de dioxyde de silicium est d'abord déposé, par exemple par dépôt chimique en phase vapeur assisté par plasma (PECVD) du côté de la face supérieure de la structure de la figure 12A. Des étapes de photolithographie puis gravure permettent ensuite de conserver uniquement des parties de la couche ou de l'empilement qui sont situées aux emplacements souhaités des îlots 701.

Lors d'étapes ultérieures, le matériau à changement de phase est déposé du côté de la face supérieure du substrat 101. Une couche optionnelle de passivation identique ou analogue à la couche 303 du commutateur 300 peut être déposée sur le matériau à changement de phase pour le protéger contre l'oxydation. Des étapes de photolithographie puis gravure permettent ensuite de conserver le matériau à changement de phase, et éventuellement le matériau de la couche optionnelle de passivation, à l'emplacement souhaité de la région 109.

On peut ensuite procéder au dépôt de la couche 111, par exemple en formant une couche de nitrure de silicium par dépôt chimique en phase vapeur assisté par plasma (PECVD) ou une couche de nitrure d'aluminium par dépôt physique en phase vapeur (PVD). Dans le cas où la couche 111 électriquement isolante revêt les électrodes 105a et 105b, des ouvertures peuvent alors être formées, par exemple par photolithographie puis gravure, par exemple gravure ionique réactive (RIE), dans la couche 111 de sorte à exposer des parties de la face supérieure de chaque électrode 105a, 105b.

L'élément chauffant 113 peut ensuite être formé, par exemple par une étape de dépôt d'un niveau de métallisation du côté de la face supérieure du substrat 101, suivie d'étapes de photolithographie puis gravure. Au cours de cette étape, des vias conducteurs peuvent en outre être réalisés dans les ouvertures préalablement formées de sorte à reprendre les contacts des électrodes 105a et 105b du commutateur.

La personne du métier est capable d'adapter le procédé de fabrication du commutateur 700 décrit ci-dessus en relation avec les figures 12A et 12B pour réaliser les commutateurs 900, 1000 et 1100.

Les modes de réalisation des commutateurs 300 et 500 précédemment exposés en relation avec les figures 3 à 5 sont combinables avec les modes de réalisation des commutateurs 700, 900, 1000 et 1100 des figures 7 à 11. Plus précisément, on peut prévoir de former, dans la région 109 en matériau à changement de phase des commutateurs 700, 900, 1000 et 1100, des piliers identiques ou analogues aux piliers 301 du commutateur 300. La structure des commutateurs 700, 900, 1000 et 1100 peut en outre être modifiée pour obtenir une structure analogue à celle du commutateur 500, dans laquelle l'élément chauffant 113 est intercalé entre le substrat 101 et les électrodes de conduction 105a et 105b. La personne du métier est capable d'adapter le procédé de fabrication du commutateur 700 décrit ci-dessus en relation avec les figures 12A et 12B pour réaliser ces différentes structures.

Les figures 13A à 13D illustrent, par des vues en coupe schématiques et partielles, des étapes successives d'un exemple d'un procédé de fabrication d'un commutateur 1300 à base d'un matériau à changement de phase selon un mode de réalisation en dehors de la présente invention.

Le commutateur 1300 comprend des éléments communs avec le commutateur 100 des figures 1 et 2. Ces éléments communs ne seront pas détaillés à nouveau ci-après.

La figure 13A illustre plus précisément une structure obtenue après des étapes de formation de la couche électriquement isolante 103, du côté de la face supérieure du substrat 101, de réalisation des électrodes de conduction 105a et 105b, et de dépôt puis de planarisation de la couche 107. Ces étapes sont par exemple mises en oeuvre comme exposé précédemment en relation avec les figures 6A et 6B. Des étapes de réalisation de la région 109 en matériau à changement de phase et de la couche de passivation 303 sont ensuite mises en oeuvre, par exemple comme exposé précédemment en relation avec la figure 6B.

La figure 13B illustre plus précisément une structure obtenue à l'issue d'une étape de dépôt de la couche électriquement isolante 307 du côté de la face supérieure de la structure de la figure 13A, suivie d'une étape de dépôt d'une autre couche électriquement isolante 1301 revêtant la couche 307. La couche 1301 est par exemple ensuite planarisée, par exemple par polissage mécano-chimique, de sorte à obtenir une structure présentant une face supérieure plane. À titre d'exemple, la couche 1301 est en dioxyde de silicium ou en nitrure d'aluminium.

La figure 13C illustre plus précisément une structure obtenue à l'issue d'une étape de formation d'un élément chauffant 1303 sur et en contact avec la face supérieure de la couche 307, à l'aplomb de la région 109. L'élément chauffant 1303 est par exemple identique ou similaire à l'élément chauffant 113 du commutateur 100. Au cours de cette étape, une ouverture est par exemple formée dans la couche 1301, par exemple par photolithographie puis gravure, à l'emplacement souhaité de l'élément chauffant 1303. L'ouverture est ensuite intégralement comblée par le ou les matériaux de l'élément chauffant 1303 puis une étape de planarisation, par exemple par polissage mécano-chimique, est mise en oeuvre de sorte à obtenir une structure présentant une face supérieure plane, l'élément chauffant 1303 affleurant la face supérieure de la couche 1301. Une étape ultérieure de dépôt d'une couche électriquement isolante 1305 du côté de la face supérieure de la structure est ensuite mise en oeuvre. La couche 1305 revêt plus précisément la face supérieure de la couche 1301 et la face supérieure de l'élément chauffant 1303. À titre d'exemple, la couche 1305 est en nitrure d'aluminium.

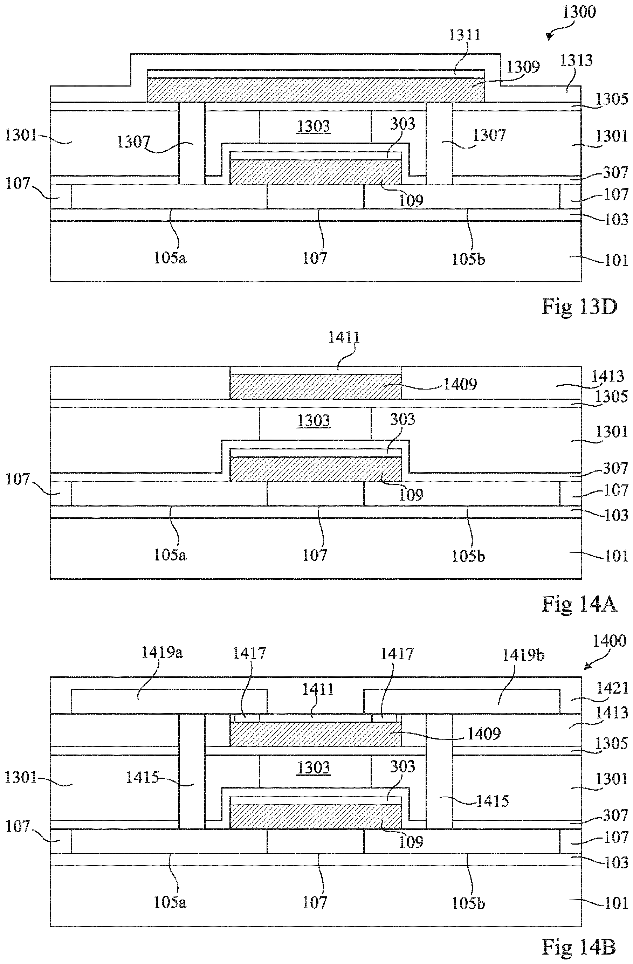

La figure 13D illustre plus précisément la structure du commutateur 1300 obtenue à l'issue d'étapes successives de formation de vias conducteurs 1307 s'étendant chacun verticalement depuis la face supérieure de la couche 1305 jusqu'à la face supérieure de l'une des électrodes de conduction 105a, 105b du commutateur 1300, de réalisation d'une autre région 1309 en matériau à changement de phase revêtue d'une autre couche 1311 de passivation, et de dépôt d'une couche électriquement isolante 1313 du côté de la face supérieure de la structure.

Les vias conducteurs 1307 sont par exemple réalisés en formant des ouvertures à travers toute l'épaisseur des couches 1305, 1301 et 307 de sorte à exposer une partie de la face supérieure de chaque électrode 105a, 105b, par exemple par photolithographie puis gravure, aux emplacements souhaités des vias 1307. Les ouvertures sont ensuite intégralement comblées par le matériau des vias conducteurs 1307, puis une étape de planarisation, par exemple par polissage mécano-chimique, est mise en oeuvre de sorte à obtenir une structure présentant une face supérieure plane, les vias conducteurs 1307 affleurant la face supérieure de la couche 1305. À titre d'exemple, les vias conducteurs 1307 sont en tungstène.

La région 1309 et la couche 1311 sont par exemple réalisées comme exposé précédemment, par exemple en relation avec la figure 6C, pour la région 109 et la couche 303. À titre d'exemple, la région 1309 et la couche 1311 sont respectivement en les mêmes matériaux que la région 109 et la couche 303.

Dans l'exemple représenté, la couche 1313 revêt la face supérieure et les flancs de la couche 1311, les flancs de la région 1309 et des parties de la face supérieure de la couche 1305 non revêtues par la région 1309. La couche 1313 permet par exemple de passiver le commutateur 1300 afin de le protéger contre l'oxydation.

Les régions 109 et 1309 en matériau à changement de phase sont connectées chacune à l'une des électrodes de conduction 105a et 105b au moyen des vias conducteurs 1307, la région 1309 étant, dans l'orientation de la figure 13D, située au-dessus de la région 109. L'élément chauffant 1303, situé entre les régions 109 et 1309, est électriquement isolé de la région 109 par la couche 307 et de la région 1309 par la couche 1305.

Les régions 109 et 1309 en matériau à changement de phase du commutateur 1300 peuvent présenter chacune une épaisseur deux fois moins importante que l'épaisseur T de la couche 109 du commutateur 100 tout en permettant au commutateur 1300 de conserver une résistance à l'état passant $R_{ON}$ sensiblement égale à celle du commutateur 100. Cela permet avantageusement aux régions 109 et 1309 de présenter une meilleure qualité cristalline. L'utilisation de régions 109 et 1309 plus minces que la région 109 du commutateur 100 permet en outre avantageusement au commutateur 1300 d'atteindre des vitesses de commutation plus élevées, la surface du matériau à changement de phase exposée à la chaleur produite par l'élément chauffant étant, dans le commutateur 1300, sensiblement doublée par rapport au commutateur 100, pour une épaisseur cumulée de matériau à changement de phase comparable. Cela permet au commutateur 1300 de présenter de meilleures performances énergétiques que le commutateur 100, l'énergie nécessaire au changement de phase du matériau des régions 109 et 1309 étant moindre.

Les figures 14A et 14B illustrent, par des vues en coupe schématiques et partielles, des étapes successives d'un exemple d'un procédé de fabrication d'un commutateur 1400 à base d'un matériau à changement de phase selon un mode de réalisation en dehors de la présente invention.

La figure 14A illustre plus précisément une structure obtenue, par exemple à partir de la structure précédemment décrite en relation avec la figure 13C, après des étapes de réalisation, sur et en contact avec la face supérieure de la couche 1305, d'une autre région 1409 en matériau à changement de phase revêtue d'une autre couche 1411 de passivation, et de dépôt d'une couche électriquement isolante 1413 du côté de la face supérieure de la structure.

La région 1409 et la couche 1411 sont par exemple réalisées comme exposé précédemment, par exemple en relation avec la figure 6C, pour la région 109 et la couche 303. À titre d'exemple, la région 1409 et la couche 1411 sont respectivement en les mêmes matériaux que la région 109 et la couche 303.

À titre d'exemple, la couche 1413 est d'abord déposée du côté de la face supérieure de la structure après réalisation de la région 1409 et de la couche 1411. La couche 1413 peut par exemple, après dépôt, revêtir les flancs de la région 1409 et la face supérieure et les flancs de la couche 1411. Une étape de planarisation, par exemple par polissage mécano-chimique, permet ensuite d'exposer la face supérieure de la couche 1411. Après planarisation, la couche 1413 affleure par exemple la face supérieure de la couche 1411 comme dans l'exemple illustré en figure 14A.

La figure 14B illustre plus précisément une structure obtenue à l'issue d'une étape de formation de vias conducteurs 1415, s'étendant chacun verticalement depuis la face supérieure de la couche 1413 jusqu'à la face supérieure de l'une des électrodes de conduction 105a, 105b, d'une étape de formation d'autres vias conducteurs 1417, s'étendant chacun verticalement depuis la face supérieure de la couche 1411 jusqu'à la face supérieure de la région 1409 à proximité de deux côtés opposés de la région 1409, d'une étape de réalisation de deux électrodes de conduction 1419a et 1419b, respectivement connectées aux électrodes de conduction 105a et 105b, et d'une étape de dépôt d'une couche électriquement isolante 1421 du côté de la face supérieure de la structure.

Les vias conducteurs 1415 sont par exemple réalisés en formant des ouvertures à travers toute l'épaisseur des couches 1413, 1305, 1301 et 307 de sorte à exposer une partie de la face supérieure de chaque électrode 105a, 105b, par exemple par photolithographie puis gravure, aux emplacements souhaités des vias 1415. Les ouvertures sont ensuite intégralement comblées par le matériau des vias conducteurs 1415. De façon analogue, les vias conducteurs 1417 sont par exemple réalisés en formant des ouvertures à travers toute l'épaisseur de la couche 1411 de sorte à exposer des parties de la face supérieure de la couche 1409, par exemple par photolithographie puis gravure aux emplacements souhaités des vias 1417. Une étape de planarisation, par exemple par polissage mécano-chimique, est par exemple ensuite mise en oeuvre de sorte à obtenir une structure présentant une face supérieure plane, les vias conducteurs 1415 et 1417 affleurant la face supérieure de la couche 1413. À titre d'exemple, les vias conducteurs 1415 et 1417 sont en tungstène.

Les électrodes 1419a et 1419b sont par exemple formées de façon analogue à ce qui a été exposé en relation avec la figure 6A pour les électrodes 105a et 105b. Chacune des électrodes 1419a, 1419b est connectée à l'électrode 105a, 105b correspondante par l'un des vias conducteurs 1415, et à la région 1409 par l'un des vias 1417. À titre d'exemple, les électrodes 1419a et 1419b sont en le même matériau, ou comprennent le même empilement de couches de matériaux, que les électrodes 105a et 105b.

À titre d'exemple, la couche 1421 est déposée du côté de la face supérieure de la structure après réalisation des électrodes 1419a et 1419b. La couche 1413 peut par exemple, après dépôt, revêtir la face supérieure et les flancs des électrodes 1419a et 1419b. Une étape de planarisation, par exemple par polissage mécano-chimique, permet ensuite d'obtenir une structure présentant une face supérieure plane.

Le commutateur 1400 présente des avantages identiques ou similaires à ceux du commutateur 1300.

Bien que l'on ait illustré en relation avec les figures 14A et 14B un mode de mise en oeuvre d'un procédé de fabrication d'un commutateur comportant deux régions 109 et 1409 en matériau à changement de phase, la personne du métier serait capable d'adapter ce procédé pour réaliser des commutateurs comportant un nombre de régions en matériau à changement de phase supérieur à deux, c'est-à-dire une structure comprenant une alternance de couches de matériau à changement de phase et d'éléments chauffants. Cela permettrait de réduire encore davantage l'épaisseur de chaque région en matériau à changement de phase par rapport au commutateur 100 tout en conservant une résistance à l'état passant $R_{ON}$ similaire.

Les modes de réalisation des commutateurs 1300 et 1400 précédemment exposés en relation avec les figures 13D et 14B sont combinables avec le mode de réalisation du commutateur 300 de la figure 3. En particulier, on pourrait prévoir qu'au moins l'une des régions 109, 1309, 1409 en matériau à changement de phase des commutateurs 1300 et 1400 comprenne un ou plusieurs piliers, analogues aux piliers 301 du commutateur 300, s'étendant dans la région en matériau à changement de phase, le ou les piliers étant en un matériau présentant une conductivité thermique supérieure à celle du matériau à changement de phase. Les commutateurs 1300 et 1400 bénéficieraient ainsi d'avantages semblables à ceux du commutateur 300.

Les modes de réalisation des commutateurs 1300 et 1400 précédemment exposés en relation avec les figures 13D et 14B sont en outre combinables avec les modes de réalisation des commutateurs 700, 900, 1000 et 1100 des figures 7, 9, 10 et 11. En particulier, on pourrait prévoir qu'au moins l'une des régions 109, 1309, 1409 en matériau à changement de phase des commutateurs 1300 et 1400 soit développée sur une surface tridimensionnelle comprenant au moins un îlot identique ou similaire aux îlots 701.

La personne du métier est capable d'adapter le procédé de fabrication du commutateur 1300 décrit ci-dessus en relation avec les figures 13A à 13D et le procédé de fabrication du commutateur 1400 décrit ci-dessus en relation avec les figures 14A et 14D pour réaliser ces différentes structures.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

**Revendications**

1. Commutateur (300 ; 500) à base d'un matériau à changement de phase comprenant :

   - une région (109) en ledit matériau à changement de phase ; et
   - un élément chauffant (113) électriquement isolé de la région en ledit matériau à changement de phase,

   **caractérisé en ce qu'**un ou plusieurs piliers (301) s'étendent dans la région en ledit matériau à changement de phase, le ou les piliers étant en un matériau présentant une conductivité thermique supérieure à celle dudit matériau à changement de phase.

2. Commutateur selon la revendication 1, dans lequel le matériau du ou des piliers (301) est électriquement isolant.

3. Commutateur selon la revendication 1 ou 2, dans lequel le matériau du ou des piliers (301) est choisi parmi le nitrure d'aluminium et le nitrure de silicium.

4. Commutateur selon l'une quelconque des revendications 1 à 3, dans lequel ledit matériau à changement de phase est un matériau chalcogénure.

5. Commutateur selon l'une quelconque des revendications 1 à 4, dans lequel une couche électriquement isolante (307) est interposée entre l'élément chauffant (113) et la région (109) en ledit matériau à changement de phase.

6. Commutateur selon la revendication 5, dans lequel la couche électriquement isolante (307) est en le même matériau que le ou les piliers (301).

7. Commutateur selon l'une quelconque des revendications 1 à 6, dans lequel la région (109) en ledit matériau à changement de phase est plus proche d'un substrat (101), dans et sur lequel est formé le commutateur (300), que l'élément chauffant (113).

8. Commutateur selon l'une quelconque des revendications 1 à 6, dans lequel l'élément chauffant (113) est plus proche d'un substrat (101), dans et sur lequel est formé le commutateur (500), que la région (109) en ledit matériau à changement de phase.

9. Commutateur selon l'une quelconque des revendications 1 à 8, dans lequel la région (109) en ledit matériau à changement de phase est revêtue d'une couche (303) de passivation.

10. Commutateur selon l'une quelconque des revendications 1 à 9, dans lequel la région (109) en ledit matériau à changement de phase relie des première et deuxième électrodes (105a, 105b) de conduction du commutateur (300 ; 500).

11. Commutateur selon l'une quelconque des revendications 1 à 10, dans lequel chaque pilier (301) présente une dimension latérale maximale égale à environ 300 nm.

12. Commutateur selon l'une quelconque des revendications 1 à 11, dans lequel chaque pilier (301) est séparé des piliers (301) voisins par une distance de l'ordre de 300 nm.

**Patentansprüche**

1. Schalter (300; 500) auf der Basis eines Phasenwechselmaterials, der Folgendes aufweist:

   - einen Bereich (109) des Phasenwechselmaterials; und
   - ein Heizelement (113), das von dem Bereich des Phasenwechselmaterials elektrisch isoliert ist,

   **dadurch gekennzeichnet, dass** sich eine oder mehrere Säulen (301) in den Bereich des Phasenwechselmaterials erstrecken, wobei die Säule(n) aus einem Material hergestellt ist/sind, dessen Wärmeleitfähigkeit größer ist als die des Phasenwechselmaterials.

2. Schalter nach Anspruch 1, wobei das Material der Säule(n) (301) elektrisch isolierend ist.

3. Schalter nach Anspruch 1 oder 2, wobei das Material der Säule(n) (301) ausgewählt ist aus Aluminiumnitrid und Siliziumnitrid.

4. Schalter nach einem der Ansprüche 1 bis 3, wobei das Phasenwechselmaterial ein Chalkogenidmaterial ist.

5. Schalter nach einem der Ansprüche 1 bis 4, wobei eine elektrisch isolierende Schicht (307) zwischen dem Heizelement (113) und dem Bereich (109) des Phasenänderungsmaterials angeordnet ist.

6. Schalter nach Anspruch 5, wobei die elektrisch isolierende Schicht (307) aus demselben Material wie die Säule(n) (301) hergestellt ist.

7. Schalter nach einem der Ansprüche 1 bis 6, wobei der Bereich (109) des Phasenwechselmaterials näher an einem Substrat (101) liegt, in und auf dem der Schalter (300) ausgebildet ist, als das Heizelement (113).

8. Schalter nach einem der Ansprüche 1 bis 6, wobei das Heizelement (113) näher an einem Substrat (101) liegt, in und auf dem der Schalter (500) ausgebildet ist, als der Bereich des Phasenwechselmaterials.

9. Schalter nach einem der Ansprüche 1 bis 8, wobei der Bereich (109) des Phasenwechselmaterials mit einer Passivierungsschicht (303) beschichtet ist.

10. Schalter nach einem der Ansprüche 1 bis 9, wobei der Bereich (109) des Phasenwechselmaterials erste und zweite Leitungselektroden (105a, 105b) des Schalters (300; 500) verbindet.

**11.** Schalter nach einem der Ansprüche 1 bis 10, wobei jede Säule (301) eine maximale seitliche Abmessung von etwa 300 nm aufweist.

**12.** Schalter nach einem der Ansprüche 1 bis 11, wobei jede Säule (301) von benachbarten Säulen (301) durch einen Abstand in der Größenordnung von 300 nm beabstandet ist.

**Claims**

**1.** Switch (300; 500) based on a phase-change material comprising:

- a region (109) of said phase-change material; and
- a heating element (113) electrically insulated from the region of said phase-change material,

**characterized in that** one or a plurality of pillars (301) extend in the region of said phase-change material, the pillar(s) being made of a material having a thermal conductivity greater than that of said phase-change material.

**2.** Switch according to claim 1, wherein the material of the pillar(s) (301) is electrically insulating.

**3.** Switch according to claim 1 or 2, wherein the material of the pillar(s) (301) is selected from aluminum nitride and silicon nitride.

**4.** Switch according to any of claims 1 to 3, wherein said phase-change material is a chalcogenide material.

**5.** Switch according to any of claims 1 to 4, wherein an electrically insulating layer (307) is interposed between the heating element (113) and the region (109) of said phase-change material.

**6.** Switch according to claim 5, wherein the electrically insulating layer (307) is made of the same material as the pillar(s) (301).

**7.** Switch according to any of claims 1 to 6, wherein the region (109) of said phase-change material is closer to a substrate (101), inside and on top of which is formed the switch (300), than the heating element (113).

**8.** Switch according to any of claims 1 to 6, wherein the heating element (113) is closer to a substrate (101), inside and on top of which is formed the switch (500), than the region of said phase-change material.

**9.** Switch according to any of claims 1 to 8, wherein the region (109) of said phase-change material is coated with a passivation layer (303).

**10.** Switch according to any of claims 1 to 9, wherein the region (109) of said phase-change material couples first and second conduction electrodes (105a, 105b) of the switch (300; 500).

**11.** Switch according to any of claims 1 to 10, wherein each pillar (301) has a maximum lateral dimension equal to approximately 300 nm.

**12.** Switch according to any of claims 1 to 11, wherein each pillar (301) is separated from the neighboring pillars (301) by a distance in the order of 300 nm.

Fig 1

Fig 2

Fig 3

Fig 4

Fig 5

Fig 6A

Fig 6B

Fig 6C

Fig 7

Fig 8

Fig 9

Fig 10

Fig 11

107 105a 105b 107
103
107 101

Fig 12A

701
107 107
103
105a 107 105b 101

Fig 12B

303
109
107 107
103
105a 107 105b 101

Fig 13A

1301
303
109
307
107 107
103
105a 107 105b 101

Fig 13B

1305
1301
1303
303
109
307
107 107
103
105a 107 105b 101

Fig 13C

Fig 13D

Fig 14A

Fig 14B

**EP 4 311 394 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 10461253 B1
- US 9368720 B1